# EUROPEAN PATENT APPLICATION

(11) **EP 2 928 077 A1**
(43) Date of publication of application: **07.10.2015**
(21) Application number: 15161771.9
(22) Date of filing: 30.03.2015
(51) Int. Cl.: H03G 3/30, H03G 7/00

(54) **APPARATUS AND METHODS FOR SMOOTHLY MANAGING AUDIO DISCONTINUITY**

(30) Priority: 03.04.2014 US 201414244227
(71) Applicant: Analog Devices Global, Hamilton (BM)
(72) Inventor: Bregnsbo, Axel Bogdan, Norwood, MA Massachusetts 02062 (US)
(74) Representative: Beck, Simon Antony

(57) **Abstract**

Apparatus and methods for audio discontinuity management are disclosed. In certain implementations, an electronically-implemented method includes decoding one or more frames comprising digital audio data. The method further includes converting the digital audio data to an analog audio output. The method further includes detecting an indication that the digital audio data will terminate at a next frame boundary. The method further includes reducing a scale of the analog audio output, over a time period, in response to said detecting.

## Description

### BACKGROUND

### Field

Embodiments of the invention relate to electronic devices, and more particularly, to digital audio devices.

### Description of the Related Technology

Digital audio interfaces can be used in a variety of applications for transferring audio data within an electronic device or between separate electronic devices. Digital audio interfaces can be used in, for example, mobile terminals, portable speakers, computer systems, and the like. Exemplary audio interfaces can include, for example, pulse code modulation (PCM), the inter-integrated circuit (I²C™) bus, the synchronous serial interface (SSI), and the serial low-power inter-chip media bus (SLIMbus™).

Digital audio can be transmitted, for example across backplanes or cables, and converted into an analog waveform. In certain applications, properties of a digital audio interface can negatively affect analog audio performance. For example, analog audio output can be distorted, clipped, or cut-off due to artifacts introduced by the digital audio interface.

There is a need for digital audio devices having improved performance. Additionally, there is a need for improved systems and methods for managing audio discontinuity in digital audio devices.

### SUMMARY

Various implementations of systems, methods and devices within the scope of the appended claims each have several aspects, no single one of which is solely responsible for the desirable attributes described herein. Without limiting the scope of the appended claims, some prominent features are described herein.

One aspect of the subject matter disclosed provides an electronic apparatus configured to manage audio discontinuity. The apparatus includes one or more processors configured to decode one or more frames comprising digital audio data. The one or more processors are further configured to detect an indication that the digital audio data will terminate at a next frame boundary. The one or more processors are further configured to gradually reduce a scale of an analog audio output, over a time period, in response to said detection. The apparatus further includes an analog to digital converter configured to convert the digital audio data to the analog audio output.

In various embodiments, at least one frame can include the indication that the digital audio data will terminate at the next frame boundary. In various embodiments, the one or more processors can be configured to detect the indication that the digital audio data will terminate by detecting a NEXT_DEACTIVATE_CHANNEL message, or a NEXT_DEACTIVATE_CHANNEL and a RECONFIGURE_NOW message. In various embodiments, the one or more processors can be configured to detect the indication that the digital audio data will terminate by detecting a first message, or the first message and a second message, wherein the frame comprises a SLIMbus™ superframe, the first message indicates that an audio channel will or should be activated at the next superframe boundary, and the second message indicates that the first message should be made effective.

In various embodiments, the time period can include an amount of time left in a current frame. In various embodiments, the time period can include the lesser of an amount of time left in a current frame and a preset time period. In various embodiments, the time period can end at the next frame boundary. In various embodiments, the time period can include a preset time period greater than an amount of time left in a current frame.

In various embodiments, the one or more processors can be configured to gradually reduce the scale of the analog audio by reducing the scale of the analog audio from full scale to a percentage or other fraction of full scale. In various embodiments, the one or more processors can be configured to reduce the scale of the analog audio by reducing the scale of the analog audio from full scale to zero. In various embodiments, the one or more processors can be configured to reduce the scale of the analog audio by reducing the scale of the analog audio according to one of a linear, exponential, or logarithmic decay over the time period.

Another aspect provides an electronically-implemented method of managing audio discontinuity. The method includes decoding one or more frames comprising digital audio data. The method further includes converting the digital audio data to an analog audio output. The method further includes detecting an indication that the digital audio data will terminate at a next frame boundary. The method further includes reducing a scale of the analog audio output, over a time period, in response to said detecting.

In various embodiments, at least one frame can include the indication that the digital audio data will terminate at the next frame boundary. In various embodiments, detecting the indication that the digital audio data will terminate can include detecting a NEXT_DEACTIVATE_CHANNEL message, or a NEXT_DEACTIVATE_CHANNEL and a RECONFIGURE_NOW message. In various embodiments, detecting the indication that the digital audio data will terminate can include detecting a first message, or the first message and a second message, wherein the frame comprises a SLIMbus™ superframe, the first message indicates that an audio channel will or should be activated at the next superframe boundary, and the second message indicates that the first message should be made effective.

In various embodiments, the time period can include an amount of time left in a current frame. In various embodiments, the time period can include the lesser of an amount of time left in a current frame and a preset time period. In various embodiments, the time period can end at the next frame boundary. In various embodiments, the time period can include a preset time period greater than an amount of time left in a current frame.

In various embodiments, reducing the scale of the analog audio can include reducing the scale of the analog audio from full scale to a fraction or portion of full scale. In various embodiments, reducing the scale of the analog audio can include reducing the scale of the analog audio from full scale to zero. In various embodiments, reducing the scale of the analog audio can include reducing the scale of the analog audio according to one of a linear, exponential, or logarithmic decay over the time period.

Another aspect provides an apparatus for managing audio discontinuity. The apparatus includes means for decoding one or more frames comprising digital audio data. The apparatus further includes an analog-to-digital converter configured to convert the digital audio data to an analog audio output. The apparatus further includes means for detecting an indication that the digital audio data will terminate at a next frame boundary. The apparatus further includes means for gradually reducing a scale of the analog audio output, over a time period, in response to said detecting.

In various embodiments, at least one frame can include the indication that the digital audio data will terminate at the next frame boundary. In various embodiments, means for detecting the indication that the digital audio data will terminate can include means for detecting a NEXT_DEACTIVATE_CHANNEL message, or a NEXT_DEACTIVATE_CHANNEL and a RECONFIGURE_NOW message. In various embodiments, means for detecting the indication that the digital audio data will terminate can include means for detecting a first message, or the first message and a second message, wherein the frame comprises a SLIMbus™ superframe, the first message indicates that an audio channel will or should be activated at the next superframe boundary, and the second message indicates that the first message should be made effective.

In various embodiments, the time period can include an amount of time left in a current frame. In various embodiments, the time period can include the lesser of an amount of time left in a current frame and a preset time period. In various embodiments, the time period can end at the next frame boundary. In various embodiments, the time period can include a preset time period greater than an amount of time left in a current frame.

In various embodiments, means for reducing the scale of the analog audio can include means for reducing the scale of the analog audio from full scale to a fraction or portion of full scale. In various embodiments, means for reducing the scale of the analog audio can include means for reducing the scale of the analog audio from full scale to zero. In various embodiments, means for reducing the scale of the analog audio can include means for reducing the scale of the analog audio according to one of a linear, exponential, or logarithmic decay over the time period.

Another aspect provides a non-transitory computer-readable medium including code that, when executed, causes an apparatus to decode one or more frames comprising digital audio data. The medium further includes code that, when executed, causes the apparatus to convert the digital audio data to an analog audio output. The medium further includes code that, when executed, causes the apparatus to detect an indication that the digital audio data will terminate at a next frame boundary. The medium further includes code that, when executed, causes the apparatus to gradually reduce a scale of the analog audio output, over a time period, in response to said detecting.

In various embodiments, at least one frame can include the indication that the digital audio data will terminate at the next frame boundary. In various embodiments, detecting the indication that the digital audio data will terminate can include detecting a NEXT_DEACTIVATE_CHANNEL message, or a NEXT_DEACTIVATE_CHANNEL and a RECONFIGURE_NOW message. In various embodiments, detecting the indication that the digital audio data will terminate can include detecting a NEXT_DEACTIVATE_CHANNEL message, or a NEXT_DEACTIVATE_CHANNEL and a RECONFIGURE_NOW message.

In various embodiments, the time period can include an amount of time left in a current frame. In various embodiments, the time period can include the lesser of an amount of time left in a current frame and a preset time period. In various embodiments, the time period can end at the next frame boundary. In various embodiments, the time period can include a preset time period greater than an amount of time left in a current frame.

In various embodiments, reducing the scale of the analog audio can include reducing the scale of the analog audio from full scale to a fraction or portion of full scale. In various embodiments, reducing the scale of the analog audio can include reducing the scale of the analog audio from full scale to zero. In various embodiments, reducing the scale of the analog audio can include reducing the scale of the analog audio according to one of a linear, exponential, or logarithmic decay over the time period.

Details of one or more implementations of the subject matter described in this specification are set forth in the accompanying drawings and the description below. Other features, aspects, and advantages will become apparent from the description, the drawings, and the claims. Note that the relative dimensions of the following figures may not be drawn to scale.

### BRIEF DESCRIPTION OF THE DRAWINGS

Figure 1 is a schematic block diagram illustrating one embodiment of an electronic device.
Figure 2 illustrates an example digital audio superframe.
Figure 3 is an exemplary signal diagram showing communication in the electronic device of Figure 1.
Figure 4 is another exemplary signal diagram showing communication in the electronic device of Figure 1.
Figure 5 is another exemplary signal diagram showing communication in the electronic device of Figure 1.
Figure 6 is a flowchart of an exemplary process of discontinuity management.
Figure 7 is a functional block diagram of an apparatus for audio discontinuity management, in accordance with an embodiment of the invention.

### DETAILED DESCRIPTION OF EMBODIMENTS

The following detailed description of embodiments presents various descriptions of specific embodiments of the invention. However, the invention can be embodied in a multitude of different ways as defined and covered by the claims. In this description, reference is made to the drawings where like reference numerals may indicate identical or functionally similar elements.

Apparatus and methods for audio discontinuity management are provided. In certain implementations, a method includes decoding one or more frames comprising digital audio data. The method further includes converting the digital audio data to an analog audio output. The method further includes detecting an indication that the digital audio data will terminate at a next frame boundary. The method further includes reducing a scale of the analog audio output, over a time period, in response to said detecting.

In certain applications, audio artifacts can be introduced during conversion from digital to analog form. In various embodiments, such artifacts can be made less audible, or inaudible, by anticipating the artifact and ramping down output volume prior to occurrence. In various embodiments, artifacts introduced by certain digital audio interfaces can be anticipated based on an indication that the audio channel will be terminated.

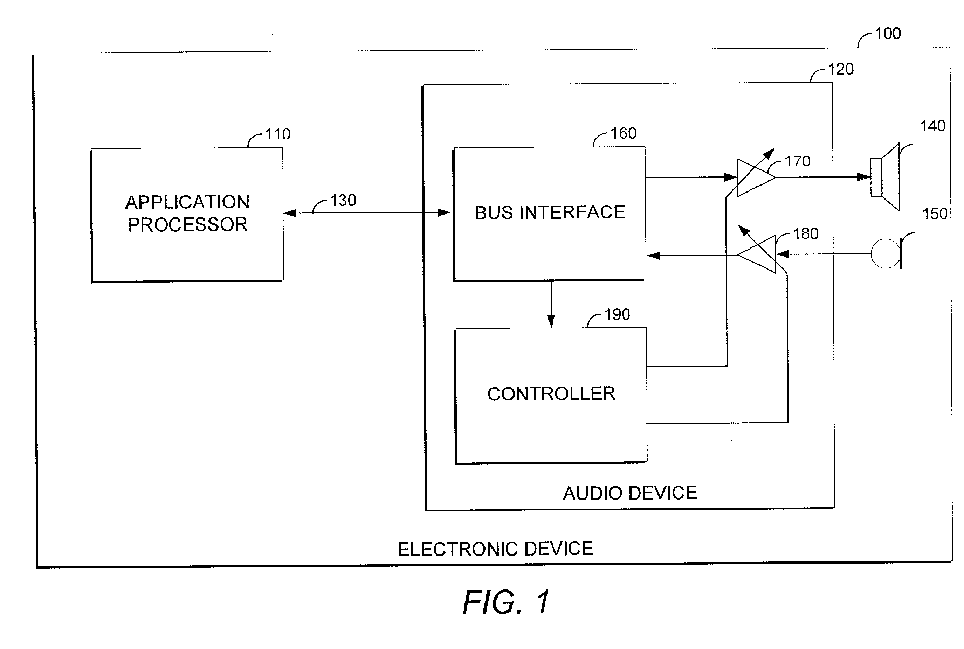

Figure 1 is a schematic block diagram illustrating one embodiment of an electronic device 100. In various embodiments, the electronic device 100 can include a mobile terminal such as a cellular telephone, a portable audio device such as a Bluetooth™ speaker, a computer system, or the like. The electronic device 100 includes an application processor 110, an audio device 120, a communication bus 130, a speaker 140, and a microphone 150. Although the electronic device 100 is described herein with reference to particular components arranged in a particular configuration, in various embodiments, components herein can be combined, divided, arranged in a different order, or omitted, and additional components can be added.

The application processor 110 serves to provide digital audio to the audio device 120, via the communication bus 130. Alternatively, or additionally, the application processor 110 can be configured to receive digital audio from the audio device 120. In various embodiments, the application processor 110 can be configured to provide or receive digital audio data via the SLIMbus™ interface.

In various embodiments, the application processor 110 can include a system on a chip (SoC) designed to support applications running in a mobile operating system environment. For example, the application processor 110 can provide a self-contained operating environment that delivers all system capabilities needed to support the electronic device's 100 applications, including memory management, graphics processing, and/or multimedia decoding. For example, the application processor 110 can include one or more processors, memories, and communication interfaces. In various embodiments, the application processor 110 can be independent from, or integrated with, one or more other specialized processors in the electronic device 100, such as a wireless communications processor (not shown), and the audio device 120.

The audio device 120 serves to convert digital audio received from the application processor 110 (or another source) into analog audio output to the speaker 140. Alternatively, or additionally, the audio device 120 can be configured to convert analog audio received from the microphone 150 into digital audio transmitted to the application processor 110 (or another destination). In various embodiments, the audio device 120 can include a system on a chip (SoC) or a combination of separate components.

In the illustrated embodiment, the audio device 120 includes a bus interface 160, an output amplifier 170, an input amplifier 180, and a controller 190. Although the audio device 120 is described herein with reference to particular components arranged in a particular configuration, in various embodiments, components herein can be combined, divided, arranged in a different order, or omitted, and additional components can be added.

The bus interface 160 serves to send and/or receive digital audio communications via the communication bus 130. The bus interface 160 is configured to decode the digital audio communications and output analog audio to the output amplifier 170. Alternatively or additionally, the bus interface 160 can be configured to encode analog audio communications received from the input amplifier 180. The bus interface 160 is further configured to provide information to the controller 190.

In various embodiments, the bus interface 160 can include a system on a chip (SoC) or a combination of separate components. For example, the bus interface 160 can include one or more processors, memories, communication interfaces, digital signal processors (DSPs), analog-to-digital converters (ADCs), and digital-to-analog converters (DACs). In various embodiments, the bus interface 160 can include a SLIMbus™ generic device, manager device, framer device, or interface device.

The output amplifier 170 serves to amplify analog audio received from the bus interface 160, according to one or more control signals received from the controller 190. The output amplifier 170 is configured to output amplified audio to the speaker 140. For example, the output amplifier 170 can include a variable-gain or voltage-controlled amplifier configured to vary its gain depending on a control voltage received from the controller 190.

The input amplifier 180 serves to amplify analog audio received from the microphone 150, according to one or more control signals received from the controller 190. The input amplifier 180 is configured to output amplified audio to the bus interface 160. For example, the input amplifier 180 can include a variable-gain or voltage-controlled amplifier configured to vary its gain depending on a control voltage received from the controller 190.

The controller 190 serves to control amplification at the output amplifier 170 and/or the input amplifier 180. For example, the controller 190 can control amplification at the output amplifier 170 based on an indication that digital audio will be terminated. In various embodiments, the controller 190 can receive the indication that digital audio will be terminated from the bus interface 160. In other embodiments, the controller 190 can be connected to the communication bus 130 and can detect the indication that digital audio will be terminated without input from the bus interface 160. In various embodiments, the indication that digital audio will be terminated can include one or more of a SLIMbus™ NEXT_ACTIVATE_CHANNEL message, a NEXT_DEACTIVATE_CHANNEL message and a RECONFIGURE_NOW message.

The communication bus 130 serves to convey one or more signals between the application processor 110, the audio device 120, and/or any number of additional devices. In some embodiments, the communication bus 130 can include a SLIMbus™ communication bus. For example, the communication bus 130 can include a single data line and a single clock line.

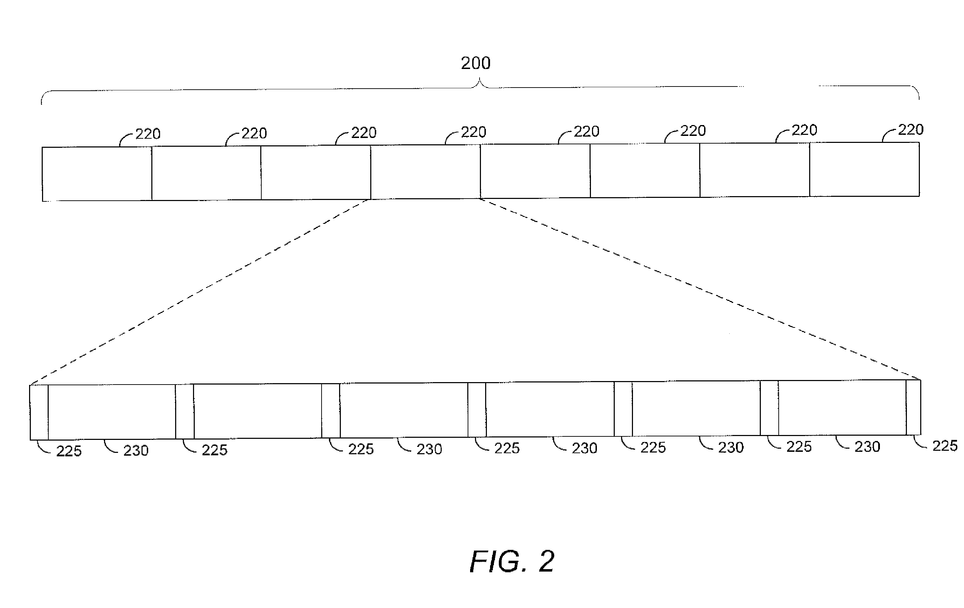

Figure 2 illustrates an example digital audio superframe 200. The digital audio superframe 200 can convey digital audio information, for example between the application processor 110 and the audio device 120, described above with respect to Figure 1. In various embodiments, the digital audio superframe 200 can include, for example, a SLIMbus™ superframe. In the illustrated embodiment, the digital audio superframe 200 includes eight digital audio frames 220. A person having ordinary skill in the art will appreciate that the digital audio superframe 200, and fields in the digital audio superframe 200, can be of different suitable lengths, and fields can be added, omitted, or rearranged. In certain embodiments, the eight digital audio frames 220 are contiguous.

In various embodiments, each digital audio frame 220 can include 192 four-bit slots, which can be allocated among control slots 225 and subframes 230. In the illustrated embodiment, each digital audio frame 220 includes seven control slots 225 and six subframes 230, each subframe 230 including 32 slots. In some embodiments, one or more control slots 225 can include frame synchronization information and/or framing information. A person having ordinary skill in the art will appreciate that each digital audio frame 220, and fields in each digital audio frame 220, can be of different suitable lengths, and fields can be added, omitted, or rearranged.

In various embodiments, one or more of the subframes 230 can include digital audio data. One or more control slots 225 can include control messages such as, for example, an indication that audio data will start, an indication that audio data will terminate, an instruction to apply one or more previous indications, etc. For example, the control slots 225 can include a NEXT_ACTIVATE_CHANNEL message according to the SLIMbus™ interface. The NEXT_ACTIVATE_CHANNEL message can indicate that audio data will start at the beginning of the next superframe 200. As another example, the control slots 225 can include a NEXT_DEACTIVATE_CHANNEL message according to the SLIMbus™ interface. The NEXT_DEACTIVATE_CHANNEL message can indicate that audio data will terminate at the beginning of the next superframe 200. As another example, the control slots 225 can include a RECONFIGURE_NOW message according to the SLIMbus™ interface. The RECONFIGURE_NOW message can indicate that previous indications and/or instructions should be applied.

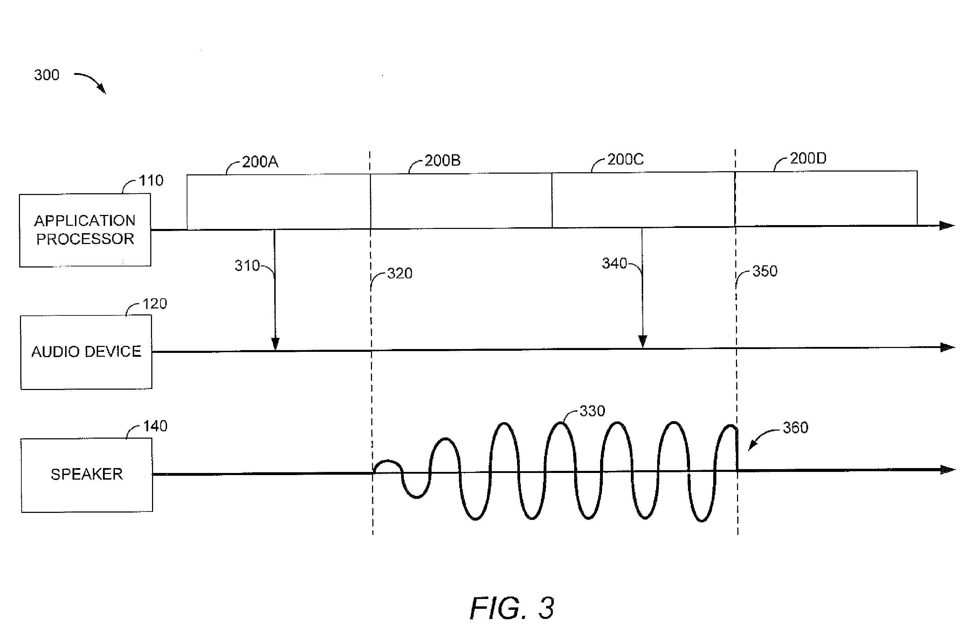

In some embodiments, digital audio can be communicated in frames and/or superframes such as the digital audio superframe 200. Moreover, in certain applications, digital audio can be enabled and/or disabled only at a superframe boundary. On the other hand, source audio does not typically end exactly at a superframe boundary. Accordingly, terminating an audio channel at the superframe boundary can introduce artifacts into an analog audio output, as discussed in greater detail below with respect to Figure 3.

Figure 3 is an exemplary signal diagram 300 showing communication in the electronic device of Figure 1. The signal diagram 300 shows communication from the application processor 110 (Figure 1) to the audio device 120 (Figure 1), as well as the speaker 140 output, over time. As shown, the application processor 110 transmits a series of superframes 200A-200D to the audio device 120. In the illustrated embodiment, only the superframes 200B and 200C contain digital audio data for the audio device 120.

In the illustrated embodiment, the first superframe 200A includes an indication 310 that audio data will start at the beginning of the next superframe 200B. In various embodiments, the indication 310 can include a NEXT_ACTIVATE_CHANNEL message, alone or in conjunction with a subsequent RECONFIGURE_NOW message. Accordingly, at the next superframe boundary 320, the audio device 120 starts decoding the digital audio data in the second superframe 200B. As discussed above with respect to Figure 1, the speaker 140 can receive analog audio from the audio device 120. Accordingly, at the superframe boundary 320, the speaker 140 begins to output an audio signal 330.

In the illustrated embodiment, the third superframe 200C includes an indication 340 that audio data will terminate at the beginning of the next superframe 200D. In various embodiments, the indication 340 can include a NEXT_DEACTIVATE_CHANNEL message, alone or in conjunction with a subsequent RECONFIGURE_NOW message. Accordingly, at the next superframe boundary 350, the audio device 120 stops decoding the digital audio data in the third superframe 200C.

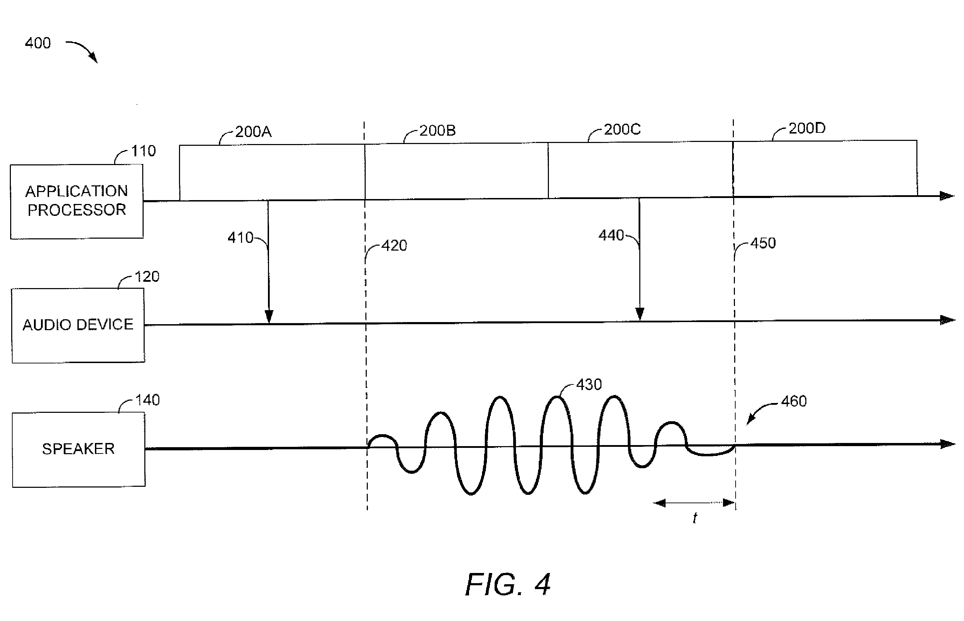

As discussed above, the digital audio data included in the superframe 200C may not end at the superframe boundary 350. Accordingly, termination of audio output can cause a discontinuity 360, glitch, click, or other artifact at the superframe boundary 350. Perceptually, the discontinuity 360 can be unpleasant or abrupt. In various embodiments, the audio device 120 can be configured to ramp down the analog audio output to the speaker 140 in a gradual manner in order to gracefully reduce or eliminate perception of the discontinuity 360. An example of such ramped-down audio output is discussed below with respect to Figure 4.

Figure 4 is another exemplary signal diagram 400 showing communication in the electronic device of Figure 1. The signal diagram 400 shows communication from the application processor 110 (Figure 1) to the audio device 120 (Figure 1), as well as the speaker 140 output, over time. As shown, the application processor 110 transmits a series of superframes 200A-200D to the audio device 120. In the illustrated embodiment, only the superframes 200B and 200C contain digital audio data for the audio device 120.

In the illustrated embodiment, the first superframe 200A includes an indication 410 that audio data will start at the beginning of the next superframe 200B. In various embodiments, the indication 410 can include a NEXT_ACTIVATE_CHANNEL message, alone or in conjunction with a subsequent RECONFIGURE_NOW message. Accordingly, at the next superframe boundary 420, the audio device 120 starts decoding the digital audio data in the second superframe 200B. As discussed above with respect to Figure 1, the speaker 140 can receive analog audio from the audio device 120. Accordingly, at the superframe boundary 420, the speaker 140 begins to output an audio signal 430.

In the illustrated embodiment, the third superframe 200C includes an indication 440 that audio data will terminate at the beginning of the next superframe 200D. In various embodiments, the indication 440 can include a NEXT_DEACTIVATE_CHANNEL message, alone or in conjunction with a subsequent RECONFIGURE_NOW message. Accordingly, at the next superframe boundary 450, the audio device 120 stops decoding the digital audio data in the third superframe 200C.

Prior to termination of audio decoding at the superframe boundary 450, the audio device 120 can detect the indication 440 and can anticipate the discontinuity 360 (Figure 3). For example, the bus interface 160 (Figure 1) can detect the NEXT_DEACTIVATE_CHANNEL and/or RECONFIGURE_NOW message and can inform the controller 190 that the indication 440 has been detected. In another embodiment, the controller 190 (Figure 1) can directly detect the indication 440.

In response to detecting the indication 440, the audio device 120 can ramp down audio output to the speaker 140 (Figure 1). For example, the audio device 120 can determine a ramp down period *t* over which to reduce the audio output. In some embodiments, the ramp down period *t* can be the time remaining in the current superframe 200C. In some embodiments, the ramp down period *t* can be a preset or dynamically determined amount of time such as, for example between 1/8 and 1/2 seconds, between 2/8 and 3/8 seconds, or more particularly 1/4 seconds. In some embodiments, the ramp down period *t* can be the lesser of the time remaining in the current superframe 200C and a preset amount of time.

In various embodiments, the audio device 120 can ramp down audio output by reducing amplification at the output amplifier 170 (Figure 1). For example, the controller 190 (Figure 1) can ramp down a control voltage to the output amplifier 170. In various embodiments, the audio device 120 can ramp down the output audio from full scale (FS) to zero over the course of the ramp down period *t*. In various embodiments, the audio device 120 can ramp down the output audio from FS to a preset or dynamically determined fraction or portion of FS over the course of the ramp down period *t*. In various embodiments, the audio device 120 can ramp down the output audio based on one or more of a linear, exponential, and logarithmic decay.

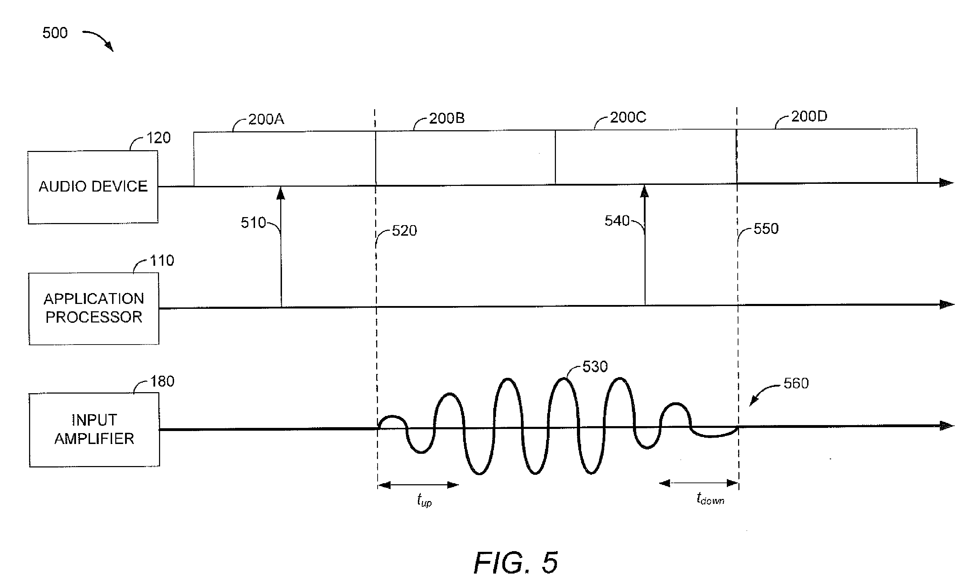

Although various systems and methods are described herein with respect to ramping down analog audio output, the techniques can also be used for analog audio input, as discussed below with respect to Figure 5.

Figure 5 is another exemplary signal diagram 500 showing communication in the electronic device of Figure 1. The signal diagram 500 shows communication between the application processor 110 (Figure 1) and the audio device 120 (Figure 1), as well as input amplifier 180 (Figure 1) output, over time. As shown, the audio device 120 transmits a series of superframes 200A-200D to the application processor 110. In the illustrated embodiment, only the superframes 200B and 200C contain digital audio data from the audio device 120, for example from the microphone 150 (Figure 1)

In the illustrated embodiment, the first superframe 200A includes an indication 510 that audio data should start at the beginning of the next superframe 200B. In various embodiments, the indication 510 can include a NEXT_ACTIVATE_CHANNEL message, alone or in conjunction with a subsequent RECONFIGURE_NOW message. In various embodiments, the NEXT_ACTIVATE_CHANNEL message can indicate that an audio channel will or should begin at the next superframe boundary. In various embodiments, the RECONFIGURE_NOW message can indicate that the NEXT_ACTIVATE_CHANNEL message should be made effective, for example upon receipt of the RECONFIGURE_NOW message. Accordingly, at the next superframe boundary 520, the audio device 120 starts encoding the digital audio data in the second superframe 200B. As discussed above with respect to Figure 1, the audio device 120 can receive analog audio from the microphone 150.

At the superframe boundary 520, the audio device 120 can ramp up audio input to from the microphone 150 (Figure 1). For example, the audio device 120 can determine a ramp up period *tᵤₚ* over which to increase the audio output. In some embodiments, the ramp up period *tᵤₚ* can be a preset or dynamically determined amount of time such as, for example between 1/8 and 1/2 seconds, between 2/8 and 3/8 seconds, or more particularly 1/4 seconds. In various embodiments, the audio device 120 can ramp up audio output to the speaker 140 (Figure 1) in the same manner.

In various embodiments, the audio device 120 can ramp up audio input by increasing amplification at the input amplifier 180 (Figure 1). For example, the controller 190 (Figure 1) can ramp up a control voltage to the input amplifier 180. In various embodiments, the audio device 120 can ramp up the input audio from zero to full scale (FS) over the course of the ramp up period *tᵤₚ.* In various embodiments, the audio device 120 can ramp up the input audio from a preset or dynamically determined fraction or portion of FS to FS over the course of the ramp up period *tᵤₚ.* In various embodiments, the audio device 120 can ramp up the input audio based on one or more of a linear, exponential, and logarithmic basis.

In the illustrated embodiment, the third superframe 200C includes an indication 540 that audio data should terminate at the beginning of the next superframe 200D. In various embodiments, the indication 540 can include a NEXT_DEACTIVATE_CHANNEL message, alone or in conjunction with a subsequent RECONFIGURE_NOW message. In various embodiments, the NEXT_DEACTIVATE_CHANNEL message can indicate that an audio channel will or should terminate at the next superframe boundary. In various embodiments, the RECONFIGURE_NOW message can indicate that the NEXT_DEACTIVATE_CHANNEL message should be made effective, for example upon receipt of the RECONFIGURE_NOW message. Accordingly, at the next superframe boundary 550, the audio device 120 stops encoding the digital audio data in the third superframe 200C.

Prior to termination of audio decoding at the superframe boundary 550, the audio device 120 can detect the indication 540 and can anticipate discontinuity. For example, the bus interface 160 (Figure 1) can detect the NEXT_DEACTIVATE_CHANNEL and/or RECONFIGURE_NOW message and can inform the controller 190 that the indication 540 has been detected. In another embodiment, the controller 190 (Figure 1) can directly detect the indication 540.

In response to detecting the indication 540, the audio device 120 can ramp down audio input from the microphone 150 (Figure 1). For example, the audio device 120 can determine a ramp down period *t_{down}* over which to reduce the audio output. In some embodiments, the ramp down period *t_{down}* can be the time remaining in the current superframe 200C. In some embodiments, the ramp down period *t_{down}* can be a preset or dynamically determined amount of time such as, for example between 1/8 and 1/2 seconds, between 2/8 and 3/8 seconds, or more particularly 1/4 seconds. In some embodiments, the ramp down period *t_{down}* can be the lesser of the time remaining in the current superframe 200C and a preset amount of time.

In various embodiments, the audio device 120 can ramp down audio input by reducing amplification at the input amplifier 180 (Figure 1). For example, the controller 190 (Figure 1) can ramp down a control voltage to the input amplifier 180. In various embodiments, the audio device 120 can ramp down the input audio from full scale (FS) to zero over the course of the ramp down period *t_{down}.* In various embodiments, the audio device 120 can ramp down the input audio from FS to a preset or dynamically determined fraction or portion of FS over the course of the ramp down period *t_{down}.* In various embodiments, the audio device 120 can ramp down the input audio based on one or more of a linear, exponential, and logarithmic decay.

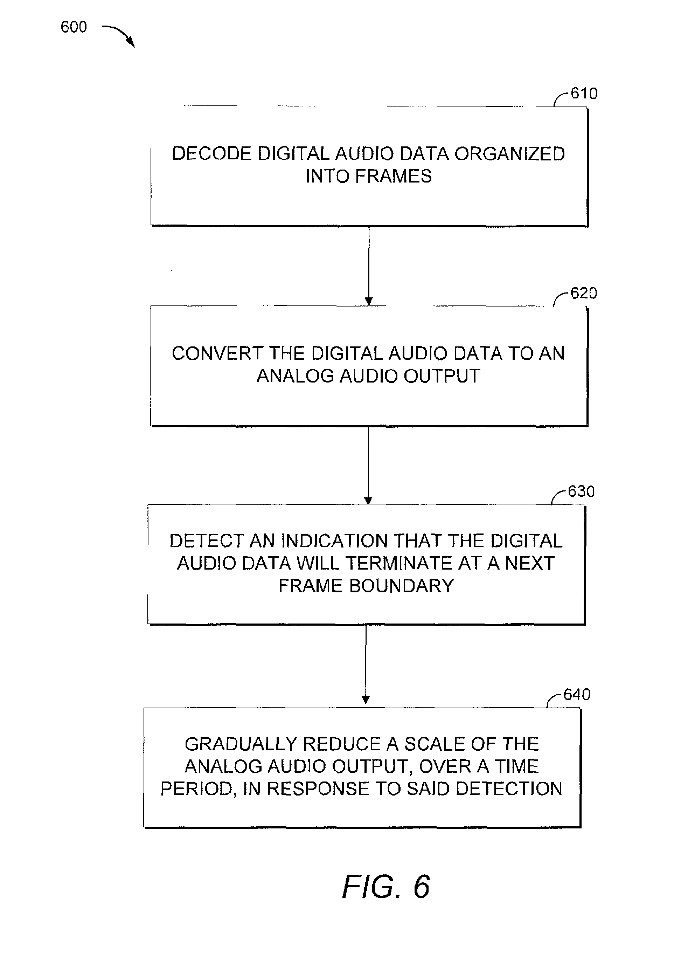

Figure 6 is a flowchart 600 of an exemplary process of discontinuity management. Although the process of flowchart 600 is described herein with reference to the electronic device 100 discussed above with respect to Figure 1, and the superframe 200 discussed above with respect to Figure 2, person having ordinary skill in the art will appreciate that the process of flowchart 600 can be implemented by another device described herein, or any other suitable device. In an embodiment, the steps of the process depicted in the flowchart 600 can be performed by a processor or controller. Although the process of flowchart 600 is described herein with reference to a particular order, in various embodiments, blocks herein can be performed in a different order, or omitted, and additional blocks can be added.

First, at block 610, an apparatus decodes digital audio data organized into frames. For example, the audio device 120 can receive one or more superframes 200, including digital audio data, from the application processor 110. In particular, the bus interface 160 can decode the superframes 200 according to the frame format discussed above with respect to Figure 2.

Next, at block 620, the apparatus converts the digital audio data to an analog audio output. For example, the audio device 120 can output analog audio to the speaker 140. In particular, the bus interface 160 can perform analog-to-digital signal conversion on the digital audio data received from the application processor 110. The output amplifier 170 can amplify the converted analog signal for output to the speaker 140.

Then, at block 630, the apparatus detects an indication that the digital audio data will terminate at the next frame boundary. For example, the audio device 120 can detect an indication such as, for example, a NEXT_DEACTIVATE_CHANNEL message or a RECONFIGURE_NOW message. In various embodiments, the bus interface 160 and/or the controller 190 can detect the indication.

In various embodiments, at least one frame can include the indication that the digital audio data will terminate at the next frame boundary. For example, the superframe 200 can include one or more control slots 225 that can include the indication As another example, a current superframe 200C (Figure 4) can include the indication 440 that the indication that the digital audio data will terminate at the next frame boundary 450 (Figure 4). In various embodiments, detecting the indication that the digital audio data will terminate can include detecting a first message, or the first message and a second message, wherein the frame comprises a SLIMbus™ superframe, the first message indicates that an audio channel will or should be activated at the next superframe boundary, and the second message indicates that the first message should be made effective. For example, detecting the indication that the digital audio data will terminate can include detecting a NEXT_DEACTIVATE_CHANNEL message, or a NEXT_DEACTIVATE_CHANNEL and a RECONFIGURE_NOW message.

Thereafter, at block 640, the apparatus gradually reduces a scale of the analog audio output, over a time period, in response to said detection. For example, the audio device 120 can ramp down the analog audio output, over the ramp down period *t*, in response to detecting a NEXT_DEACTIVATE_CHANNEL message or a RECONFIGURE_NOW message. In particular, the controller 190 can determine the ramp down period *t* and can adjust amplification at the output amplifier 170 as discussed above with respect to Figure 4.

In various embodiments, the time period can include an amount of time left in a current frame. For example, with reference to Figures 1 and 4, the controller 190 can calculate an amount of time left in the superframe 200C by subtracting a time of receipt of the indication 440 from a time of the superframe boundary 450.

In various embodiments, the time period can include the lesser of an amount of time left in a current frame and a preset time period. For example, with reference to Figures 1 and 4, the controller 190 can calculate an amount of time left in the superframe 200C by subtracting a time of receipt of the indication 440 from a time of the superframe boundary 450 and comparing the result to a preset time period.

In various embodiments, the time period can end at the next frame boundary. For example, with reference to Figures 1 and 4, the controller 190 can calculate a start time for the time period *t* by subtracting a preset amount of time from the superframe boundary 450.

In various embodiments, the time period can include a preset time period greater than an amount of time left in a current frame. For example, with reference to Figures 1 and 4, the controller 190 can begin the time period immediately after receipt of the indication 440. Accordingly, at the next superframe boundary 450, the output audio 430 may not be fully ramped.

In various embodiments, reducing the scale of the analog audio can include reducing the scale of the analog audio from full scale to a fraction or portion of full scale. For example, the controller 190 can reduce a control voltage of the output amplifier 170 from FS to between 0% and 20% of FS, between 5% and 15% of FS, and more particularly to 10% of FS.

In various embodiments, reducing the scale of the analog audio can include reducing the scale of the analog audio from full scale to zero. In various embodiments, reducing the scale of the analog audio can include reducing the scale of the analog audio according to one of a linear, exponential, or logarithmic decay over the time period.

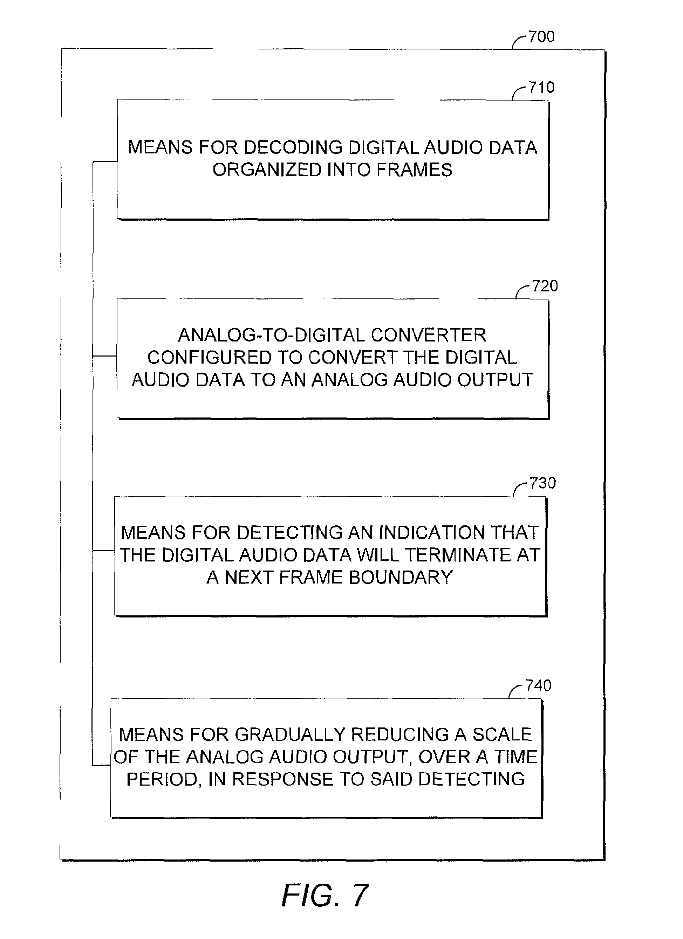

Figure 7 is a functional block diagram of an apparatus 700 for audio discontinuity management, in accordance with an embodiment of the invention. Those skilled in the art will appreciate that an apparatus for audio discontinuity management can have more components than the simplified apparatus 700 shown in Figure 7. The apparatus 700 for audio discontinuity management shown includes only those components useful for describing some prominent features of implementations within the scope of the claims. The apparatus 700 for audio discontinuity management includes means 710 for decoding digital audio data organized into frames, an analog-to-digital converter 720 configured to convert the digital audio data to an analog audio output, means 730 for detecting an indication that the digital audio data will terminate at the next frame boundary, and means 740 for gradually reducing a scale of the analog audio output, over a time period, in response to said detecting.

In an embodiment, means 710 for decoding digital audio data organized into frames can be configured to perform one or more of the functions described above with respect to block 610 (Figure 6). In various embodiments, the means 710 for decoding digital audio data organized into frames can be implemented by one or more of the bus interface 160 (Figure 1) and one or more digital signal processors (DSPs) and/or general purpose processors.

In an embodiment, the analog-to-digital converter 720 can include means for converting the digital audio data to an analog audio output, which can be configured to perform one or more of the functions described above with respect to block 620 (Figure 6). In various embodiments, the means for converting the digital audio data to an analog audio output can be implemented by one or more of the bus interface 160 (Figure 1) and one or more digital signal processors (DSPs) and/or general purpose processors.

In an embodiment, means 730 for detecting an indication that the digital audio data will terminate at the next frame boundary can be configured to perform one or more of the functions described above with respect to block 630 (Figure 6). In various embodiments, the means 730 for detecting an indication that the digital audio data will terminate at the next frame boundary can be implemented by one or more of the controller 190 (Figure 1), the bus interface 160 (Figure 1), and one or more digital signal processors (DSPs) and/or general purpose processors.

In an embodiment, means 740 for gradually reducing a scale of the analog audio output, over a time period, in response to said detecting can be configured to perform one or more of the functions described above with respect to block 640 (Figure 6). In various embodiments, the means 740 for reducing a scale of the analog audio output, over a time period, in response to said detecting can be implemented by one or more of the controller 190, the bus interface 160 (Figure 1), the output amplifier, and one or more digital signal processors (DSPs) and/or general purpose processors.

The foregoing description and claims can refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the Figures depict example arrangements of elements and components, additional intervening elements, devices, features, or components can be present in an actual embodiment (assuming that the functionality of the depicted circuits is not adversely affected).

### Applications

Devices employing the above described schemes can be implemented into various electronic devices. Examples of the electronic devices can include, but are not limited to, medical imaging and monitoring, consumer electronic products, parts of the consumer electronic products, electronic test equipment, etc. Examples of the electronic devices can also include memory chips, memory modules, circuits of optical networks or other communication networks, and disk driver circuits. The consumer electronic products can include, but are not limited to, a mobile phone, a telephone, a television, a computer monitor, a computer, a hand-held computer, a personal digital assistant (PDA), a microwave, a refrigerator, an automobile, a stereo system, a cassette recorder or player, a DVD player, a CD player, a VCR, an MP3 player, a radio, a camcorder, a camera, a digital camera, a portable memory chip, a washer, a dryer, a washer/dryer, a copier, a facsimile machine, a scanner, a multifunctional peripheral device, a wrist watch, a clock, etc. Further, the electronic device can include unfinished products.

The various operations of methods described above can be performed by any suitable means capable of performing the operations, such as various hardware and/or software component(s), circuits, and/or module(s). Generally, any operations illustrated in the figures can be performed by corresponding functional means capable of performing the operations.

Information and signals can be represented using any of a variety of different technologies and techniques. For example, data, instructions, commands, information, signals, bits, symbols, and chips that can be referenced throughout the above description can be represented by voltages, currents, electromagnetic waves, magnetic fields or particles, optical fields or particles, or any combination thereof.

The various illustrative logical blocks, modules, circuits, and algorithm steps described in connection with the embodiments disclosed herein can be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. The described functionality can be implemented in varying ways for each particular application, but such implementation decisions should not be interpreted as causing a departure from the scope of the embodiments of the invention.

The various illustrative blocks, modules, and circuits described in connection with the embodiments disclosed herein can be implemented or performed with a general purpose processor, a Digital Signal Processor (DSP), an Application Specific Integrated Circuit (ASIC), a Field Programmable Gate Array (FPGA) or other programmable logic device, discrete gate or transistor logic, discrete hardware components, or any combination thereof designed to perform the functions described herein. A general purpose processor can be a microprocessor, but in the alternative, the processor can be any conventional processor, controller, microcontroller, or state machine. A processor can also be implemented as a combination of computing devices, e.g., a combination of a DSP and a microprocessor, a plurality of microprocessors, one or more microprocessors in conjunction with a DSP core, or any other such configuration.

The steps of a method or algorithm and functions described in connection with the embodiments disclosed herein can be embodied directly in hardware, in a software module executed by a processor, or in a combination of the two. If implemented in software, the functions can be stored on or transmitted over as one or more instructions or code on a tangible, non-transitory computer-readable medium. A software module can reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art. A storage medium is coupled to the processor such that the processor can read information from, and write information to, the storage medium. In the alternative, the storage medium can be integral to the processor. Disk and disc, as used herein, includes compact disc (CD), laser disc, optical disc, digital versatile disc (DVD), floppy disk and blu ray disc where disks usually reproduce data magnetically, while discs reproduce data optically with lasers. Combinations of the above should also be included within the scope of computer readable media. The processor and the storage medium can reside in an ASIC. The ASIC can reside in a user terminal. In the alternative, the processor and the storage medium can reside as discrete components in a user terminal.

For purposes of summarizing the disclosure, certain aspects, advantages and novel features of the inventions have been described herein. It is to be understood that not necessarily all such advantages can be achieved in accordance with any particular embodiment of the invention. Thus, the invention can be embodied or carried out in a manner that achieves or optimizes one advantage or group of advantages as taught herein without necessarily achieving other advantages as can be taught or suggested herein.

Various modifications of the above described embodiments will be readily apparent, and the generic principles defined herein can be applied to other embodiments without departing from the spirit or scope of the invention. Thus, the present invention is not intended to be limited to the embodiments shown herein but is to be accorded the widest scope consistent with the principles and novel features disclosed herein.

## Claims

1. An electronic apparatus configured to manage audio discontinuity, the apparatus comprising:
one or more processing devices (120) configured to:
decode one or more frames or superframes comprising digital audio data;
detect an indication that the digital audio data should terminate at a specific time; and
gradually reduce a scale of an analog audio output, over a time period, in response to said detection; and
an analog-to-digital converter configured to convert the digital audio data to the analog audio output.

2. The electronic apparatus of Claim 1, wherein at least one frame comprises the indication that the digital audio data should terminate at the specific time.

3. The electronic apparatus of Claim 1 or 2, wherein the one or more processing devices are configured to detect the indication that the digital audio data should terminate by detecting a first message, or the first message and a second message, wherein specific time comprises a SLIMbus™ superframe boundary, the first message indicates that an audio channel will or should be terminated at the next superframe boundary, and the second message indicates that the first message should be made effective.

4. The electronic apparatus of Claim 1, 2 or 3, wherein the time period comprises an amount of time left before the specific time.

5. The electronic apparatus of Claim 1, 2 or 3, wherein the time period comprises the lesser of an amount of time left before the specific time and a preset time period.

6. The electronic apparatus of Claim 5, wherein the time period ends at the specific time.

7. The electronic apparatus of Claim 1, 2 or 3, wherein the time period comprises a preset time period greater than an amount of time left in before the specific time.

8. The electronic apparatus of any preceding Claim, wherein
a) the one or more processing devices are configured to reduce the scale of the analog audio by reducing the scale of the analog audio from full scale to a fraction or portion of full scale; or
b) the one or more processing devices are configured to reduce the scale of the analog audio by reducing the scale of the analog audio from full scale to zero.

9. The electronic apparatus of any preceding Claim, wherein the one or more processing devices are configured to reduce the scale of the analog audio by reducing the scale of the analog audio according to one of a linear, exponential, or logarithmic decay over the time period.

10. An electronically-implemented method of managing audio discontinuity, the method comprising:
decoding one or more frames or superframes comprising digital audio data;
converting the digital audio data to an analog audio output;
detecting an indication that the digital audio data should terminate at a specific time; and
gradually reducing a scale of the analog audio output, over a time period, in response to said detecting.

11. The method of Claim 10, wherein at least one frame comprises the indication that the digital audio data should terminate at the specific time.

12. The method of Claim 10 or 11, wherein detecting the indication that the digital audio data should terminate comprises detecting a first message, or the first message and a second message, wherein the specific time comprises a SLIMbus™ superframe boundary, the first message indicates that an audio channel will or should be terminated at the next superframe boundary, and the second message indicates that the first message should be made effective.

13. The method of Claim 10, 11, or 12, wherein the time period comprises
a) an amount of time left before the specific time;
b) the lesser of an amount of time left before the specific time and a preset time period; or
c) a preset time period greater than an amount of time left before the specific time

14. The method of any of Claims 10 to 13, wherein at least one of the following applies:
a) reducing the scale of the analog audio comprises reducing the scale of the analog audio from full scale to a fraction or portion of full scale, or zero;
b) reducing the scale of the analog audio comprises reducing the scale of the analog audio according to one of a linear, exponential, or logarithmic decay over the time period.

15. An apparatus for managing audio discontinuity, comprising:
a means for decoding one or more frames or superframes comprising digital audio data;
an analog-to-digital converter configured to convert the digital audio data to an analog audio output;
a means for detecting an indication that the digital audio data should terminate at a specific time; and
a means for gradually reducing a scale of the analog audio output, over a time period, in response to said detecting.
